# EUROPEAN PATENT APPLICATION

(11) **EP 4 424 539 A1**
(43) Date of publication of application: **04.09.2024**
(21) Application number: 21962451.7
(22) Date of filing: 29.10.2021
(51) Int. Cl.: B60L 3/00

(54) **ELECTRONIC DEVICE**

(71) Applicant: MITSUBISHI ELECTRIC CORPORATION, Chiyoda-ku Tokyo 100-8310 (JP)
(72) Inventor: MASUYAMA, Takahiro, Tokyo 100-8310 (JP); TAKABAYASHI, Hirokazu, Tokyo 100-8310 (JP)
(74) Representative: Witte, Weller & Partner Patentanwälte mbB
(86) International application number: PCT/JP2021/039975
(87) International publication number: WO 2023/073909

(57) **Abstract**

An electronic device (1) includes a heat-receiving block (21), a heat transfer member (22), and one or more fins (23). At least one fin of the one or more fins (23) has at least one ventilation hole (23a) to guide air in a direction away from a second main surface (21b) of the heat-receiving block (21). The at least one fin of the one or more fins (23) having the at least one ventilation hole (23a) has a first region including a middle of the at least one fin (23) having the at least one ventilation hole (23a) in a travel direction or a width direction of a vehicle and second regions located across the first region and having a same area as the first region. A ratio of an opening area of the at least one ventilation hole (23a) is higher in the first region than in the second regions.

## Description

### Technical Field

The present disclosure relates to an electronic device.

### Background Art

An electronic device may include a cooler that is thermally connected to electronic components as heating elements to reduce damage on such electronic components with heat when receiving power. An electronic device, such as a power converter, installed on a railway vehicle dissipates heat generated by such electronic components with a cooler into passing air occurring when the railway vehicle travels, thereby cooling the electronic components. Patent Literature 1 describes an example of such an electronic device. The power converter described in Patent Literature 1 is attached to the roof of a railway vehicle, and includes fins attached to an upper surface and to a side surface of a housing.

### Citation List

### Patent Literature

Patent Literature 1: Unexamined Japanese Patent Application Publication No. 2009-124038

### Summary of Invention

### Technical Problem

The power converter described in Patent Literature 1 allows passing air created by a traveling railway vehicle to flow between the fins to cool electronic components, such as a semiconductor element, accommodated in the housing of the power converter. The power converter that supplies power to electronic devices installed on the railway vehicle, for example, an air-conditioning device or a light fixture operates when the railway vehicle is traveling as well as when the railway vehicle is stopped. Thus, the electronic components in the power converter generate heat also when the railway vehicle is stopped.

Such electronic components in the power converter described in Patent Literature 1 generate heat also when the railway vehicle is stopped and are thus not fully cooled when the railway vehicle is stopped. In other words, the power converter described in Patent Literature 1 has insufficient cooling performance through natural convection. This is common to the power converter that supplies power to, for example, the air-conditioning device or the light fixture installed on the railway vehicle as well as to an electronic device including electronic components that generate heat when a vehicle is stopped, in addition to when the vehicle is traveling.

In response to the above circumstances, an objective of the present disclosure is to provide an electronic device that can cool electronic components also when a vehicle is stopped.

### Solution to Problem

To achieve the above objective, an electronic device according to an aspect of the present disclosure is installable on a vehicle. The electronic device includes a heat-receiving block being heat conductive, a heat transfer member, and one or more fins. The heat-receiving block has a first main surface to which an electronic component is attachable. The heat transfer member is attached to a second main surface of the heat-receiving block. The second main surface is opposite to the first main surface. The heat transfer member extends away from the second main surface to transfer, in a direction away from the second main surface, heat transferred from the electronic component through the heat-receiving block. The one or more fins are attached to the heat transfer member to dissipate heat transferred from the electronic component through the heat-receiving block and the heat transfer member into ambient air. At least one fin of the one or more fins has at least one ventilation hole to guide the ambient air in the direction away from the second main surface. The at least one fin of the one or more fins having the at least one ventilation hole has a first region including a middle of the at least one fin having the at least one ventilation hole in a travel direction or a width direction of the vehicle and second regions located across the first region and having a same area as the first region. A ratio of an opening area of the at least one ventilation hole is higher in the first region than in the second regions.

### Advantageous Effects of Invention

In the electronic device according to the above aspect of the present disclosure, the ratio of the opening area of the ventilation hole is higher in the first region including the middle of the fin of the fins having the ventilation hole in the travel direction or the width direction of the vehicle than in the second regions. Thus, ambient air receiving heat transferred from the at least one fin moves from the second regions to the first region and flows in the direction away from the second main surface of the heat-receiving block through the ventilation holes in the first region. With convection of air, the electronic device can cool the electronic component also when the vehicle is stopped.

### Brief Description of Drawings

FIG. 1 is a block diagram of an electronic device according to an embodiment;
FIG. 2 is a diagram of the electronic device according to the embodiment, illustrating an example installation on a vehicle;
FIG. 3 is a cross-sectional view of the electronic device according to the embodiment taken along line III-III as viewed in the direction indicated by the arrows in FIG. 2;
FIG. 4 is a cross-sectional view of the electronic device according to the embodiment taken along line IV-IV as viewed in the direction indicated by the arrows in FIG. 3;
FIG. 5 is a top view of the electronic device according to the embodiment;
FIG. 6 is a diagram of the electronic device according to the embodiment, illustrating example passing air;
FIG. 7 is a diagram of the electronic device according to the embodiment, illustrating an example flow of natural convection;
FIG. 8 is a diagram of the electronic device according to the embodiment, illustrating an example flow of natural convection;
FIG. 9 is a cross-sectional view of an electronic device according to a first modification of the embodiment;
FIG. 10 is a cross-sectional view of the electronic device according to the first modification of the embodiment taken along line X-X as viewed in the direction indicated by the arrows in FIG. 9;
FIG. 11 is a diagram of the electronic device according to the first modification of the embodiment, illustrating an example of natural convection;
FIG. 12 is a cross-sectional view of an electronic device according to a second modification of the embodiment;
FIG. 13 is a diagram of the electronic device according to the second modification of the embodiment, illustrating an example of natural convection;
FIG. 14 is a top view of an electronic device according to a third modification of the embodiment;
FIG. 15 is a top view of an electronic device according to a fourth modification of the embodiment;
FIG. 16 is a cross-sectional view of an electronic device according to a fifth modification of the embodiment;
FIG. 17 is a diagram of the electronic device according to the fifth modification of the embodiment taken along line XVII-XVII as viewed in the direction indicated by the arrows in FIG. 16;
FIG. 18 is a top view of an electronic device according to a sixth modification of the embodiment;
FIG. 19 is a diagram of the electronic device according to the embodiment, illustrating another example installation on a vehicle; and
FIG. 20 is a cross-sectional view of the electronic device according to the embodiment taken along line XX-XX as viewed in the direction indicated by the arrows in FIG. 19.

### Description of Embodiments

An electronic device according to one or more embodiments of the present disclosure is described below in detail with reference to the drawings. In the figures, the same reference signs denote the same or equivalent components.

As an example of an electronic device, a power converter is installable on a railway vehicle to convert alternating current (AC) power supplied from an AC power supply to AC power to be supplied to a load and to supply the resulting AC power to the load. An electronic device 1 according to an embodiment is described using, in an example, a power converter installed on the roof of a railway vehicle to cool electronic components through natural convection and passing air, which is an airflow caused by a traveling railway vehicle and flowing in a direction opposite to the travel direction of the railway vehicle.

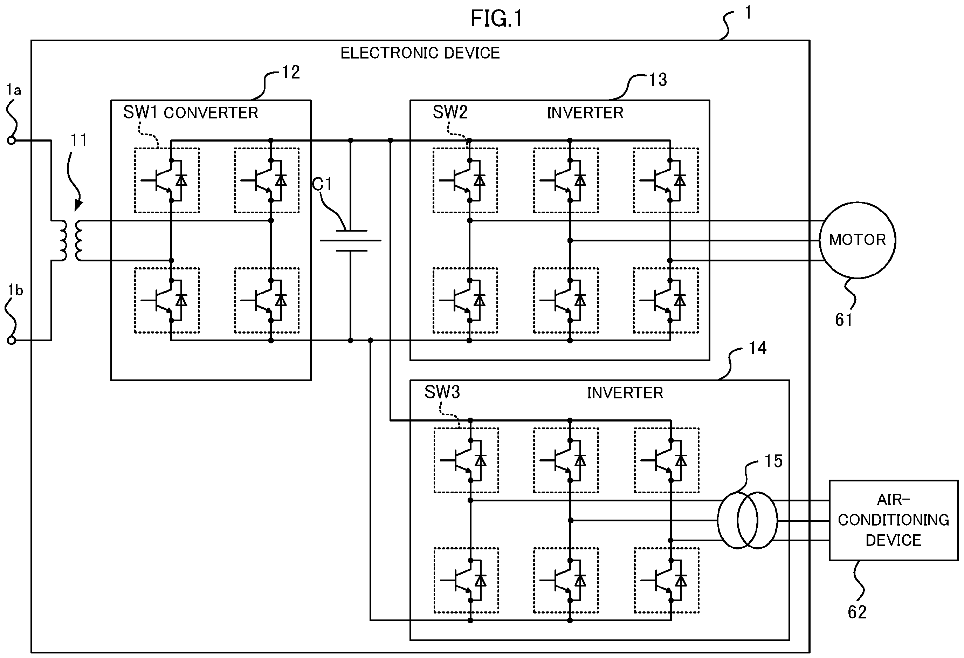

The electronic device 1 illustrated in FIG. 1 is installed on an AC feeding railway vehicle. The electronic device 1 converts supplied AC power to AC power appropriate for each of a motor 61 and an air-conditioning device 62 serving as example loads, and supplies the resulting AC power to the motor 61 and the air-conditioning device 62. The motor 61 is, for example, a three-phase induction motor that generates propulsion of the railway vehicle. Supply of power by the electronic device 1 to the motor 61 during traveling of the railway vehicle, or more specifically, during power running generates propulsion of the railway vehicle. The air-conditioning device 62 is an air conditioner in the railway vehicle. When the electronic device 1 supplies power to the air-conditioning device 62 during the operation of the railway vehicle, or more specifically, during traveling or stopping of the railway vehicle, the air-conditioning device 62 operates to adjust the temperature in the railway vehicle to an intended temperature.

The components of the electronic device 1 are described below. The electronic device 1 includes a positive terminal 1a that is connected to the power supply and a negative terminal 1b that is grounded. The electronic device 1 further includes a transformer 11 that lowers the voltage of AC power supplied from the power supply connected to the positive terminal 1a, a converter 12 that converts the AC power having the voltage lowered by the transformer 11 to direct current (DC) power, a capacitor C1 charged with the DC power output from the converter 12, and inverters 13 and 14 that convert the DC power input through the capacitor C1 to AC power.

The positive terminal 1a is electrically connected to, for example, a current collector that acquires AC power supplied from an electrical substation through a power line. The current collector corresponds to the power supply that supplies power to the electronic device 1. For example, the power line is an overhead power line or a third rail. The current collector is a pantograph or a current collector shoe. The negative terminal 1b is short-circuited to rails through a ground brush, an earth ring, or wheels, which are not illustrated, and is grounded.

The transformer 11 includes a primary winding having one end connected to the positive terminal 1a and the other end connected to the negative terminal 1b, and a secondary winding connected to the converter 12. For example, the transformer 11 lowers single-phase AC power with a voltage of 25 kV supplied from the current collector to single-phase AC power with a voltage of 1520 V, and supplies the AC power with the lowered voltage to the converter 12.

The converter 12 includes two pairs of two switching elements SW1 that are connected in series. One pair of the switching elements SW 1 is connected in parallel to the other pair of the switching elements SW1. One end of the secondary winding of the transformer 11 is connected to a point of connection between the two switching elements SW1 in one pair, and the other end of the secondary winding of the transformer 11 is connected to a point of connection between the two switching elements SW1 in the other pair.

Each switching element SW1 includes an insulated-gate bipolar transistor (IGBT) and a reflux diode including an anode connected to an emitter terminal of the IGBT and a cathode connected to a collector terminal of the IGBT. An unillustrated controller provides a gate signal to a gate terminal of the IGBT included in each switching element SW1 included in the converter 12 to turn on or off the IGBT, or in other words, to turn on or off the switching element SW1. Each switching element SW1 performs switching to cause the converter 12 to convert AC power supplied from the transformer 11 to DC power.

The capacitor C1 is charged with DC power output from the converter 12. The capacitor C1 has one end connected to a point of connection between a positive terminal of the converter 12 and primary positive terminals of the inverters 13 and 14, and the other end connected to a point of connection between a negative terminal of the converter 12 and primary negative terminals of the inverters 13 and 14.

The inverter 13 includes three pairs of two switching elements SW2 that are connected in series. The three pairs of switching elements SW2 each correspond to a U phase, a V phase, and a W phase of three-phase AC power. The switching elements SW2 corresponding to the U phase, the switching elements SW2 corresponding to the V phase, and the switching elements SW2 corresponding to the W phase are connected parallel to one another between the primary positive terminal and the primary negative terminal of the inverter 13. A point of connection between the two switching elements SW2 corresponding to the U phase, a point of connection between the two switching elements SW2 corresponding to the V phase, and a point of connection between the two switching elements SW2 corresponding to the W phase are connected to the motor 61.

Similarly to the switching elements SW1, each switching element SW2 includes an IGBT and a reflux diode. An unillustrated controller provides a gate signal to a gate terminal of the IGBT included in each switching element SW2 included in the inverter 13 to turn on or off the IGBT, or in other words, to turn on or off the switching element SW2. Each switching element SW2 performs switching to cause the inverter 13 to convert DC power to three-phase AC power and supply the three-phase AC power to the motor 61.

The inverter 14 includes three pairs of two switching elements SW3 that are connected in series. The three pairs of switching elements SW3 correspond to the U phase, the V phase, and the W phase of three-phase AC power. The switching elements SW3 corresponding to the U phase, the switching elements SW3 corresponding to the V phase, and the switching elements SW3 corresponding to the W phase are connected parallel to one another between the primary positive terminal and the primary negative terminal of the inverter 14.

Similarly to the switching elements SW1, each switching element SW3 includes an IGBT and a reflux diode. An unillustrated controller provides a gate signal to a gate terminal of the IGBT included in each switching element SW3 included in the inverter 14 to turn on or off the IGBT, or in other words, to turn on or off the switching element SW3. Each switching element SW3 performs switching to cause the inverter 14 to convert DC power to three-phase AC power.

The inverter 14 further includes a transformer 15 that lowers the voltage of the three-phase AC power converted from DC power to a voltage appropriate for the air-conditioning device 62. A point of connection between the two switching elements SW3 corresponding to the U phase, a point of connection between the two switching elements SW3 corresponding to the V phase, and a point of connection between the two switching elements SW3 corresponding to the W phase are connected to the transformer 15. The three-phase AC power with the voltage lowered by the transformer 15 is supplied to the air-conditioning device 62.

When the railway vehicle is traveling, the converter 12 and the inverters 13 and 14 are in operation. Thus, the switching elements SW1, SW2, and SW3 are repeatedly turned on and off, or more specifically, perform switching and generate heat. When the railway vehicle is stopped, the motor 61 receives no power, but the air-conditioning device 62 is to operate although the railway vehicle is stopped. Thus, when the railway vehicle is stopped, the inverter 13 is stopped, and the converter 12 and the inverter 14 are in operation. In other words, the switching elements SW2 generate no heat, whereas the switching elements SW1 and SW3 are repeatedly turned on and off and generate heat. Thus, the electronic device 1 has a structure for cooling electronic components including the switching elements SW1, SW2, and SW3 with passing air created by the traveling railway vehicle, and cools electronic components including the switching elements SW1 and SW3 through natural convection when the railway vehicle is stopped.

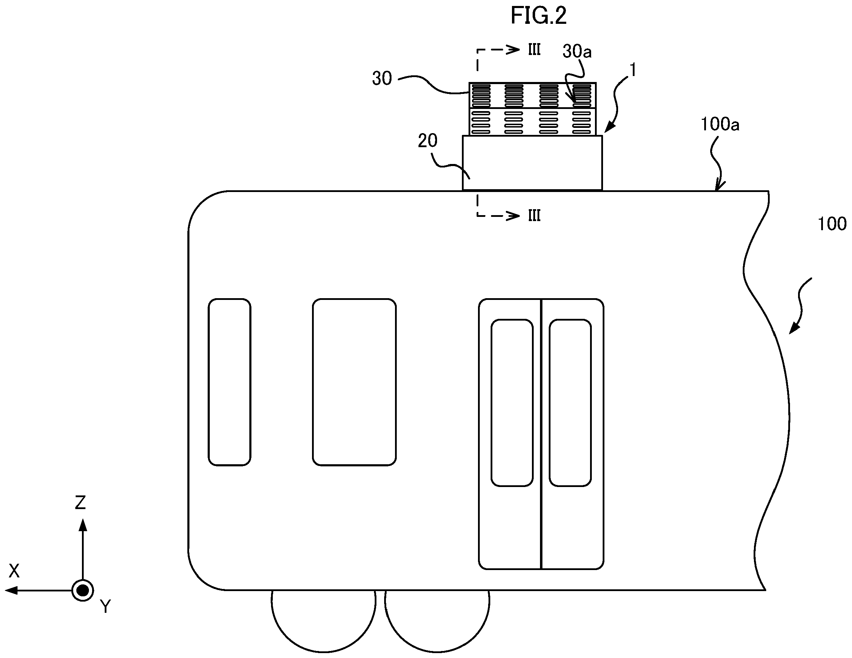

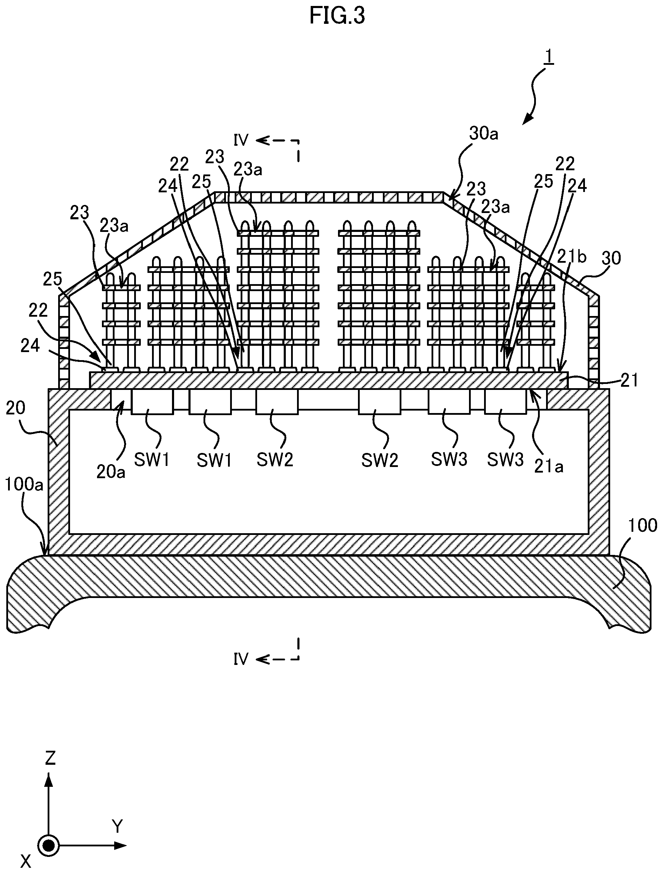

The structure of the electronic device 1 is described in detail below. As illustrated in FIG. 2, the electronic device 1 is installed on a roof 100a of a vehicle 100. As illustrated in FIG. 3 that is a cross-sectional view of the electronic device 1 taken along line III-III as viewed in the direction indicated by the arrows in FIG. 2, the electronic device 1 includes a heat-receiving block 21 that is heat conductive and has a first main surface 21a receiving electronic components, and heat transfer members 22 that are attached to a second main surface 21b of the heat-receiving block 21 to transfer, in a direction away from the second main surface 21b, heat transferred from the electronic components through the heat-receiving block 21. The electronic device 1 further includes one or more fins 23 that are attached to the heat transfer members 22 to dissipate heat transferred from the electronic components through the heat-receiving block 21 and the heat transfer members 22 into ambient air.

The electronic device 1 preferably further includes, on the roof 100a, a housing 20 accommodating the electronic components including the switching elements SW1, SW2, and SW3. The heat-receiving block 21 may be attached to the housing 20 to close an opening 20a in the housing 20. To reduce breakage of the heat transfer members 22 and the fins 23, the electronic device 1 preferably includes a cover 30 attached to the housing 20 to cover the heat transfer members 22 and the fins 23.

In FIGS. 2 and 3, Z-axis indicates a vertical direction for the vehicle 100 located horizontally. X-axis indicates a travel direction of the vehicle 100. Y-axis indicates a width direction of the vehicle 100. X-axis, Y-axis, and Z-axis are perpendicular to one another. The same applies to the subsequent figures.

The housing 20 is attached to a vertically upper portion of the roof 100a. The housing 20 has rigidity and strength enough to resist deformation under the maximum expected vibration from the railway vehicle. For example, the housing 20 is formed from metal such as iron or aluminum. The housing 20 has the opening 20a in a vertically upper portion.

The heat-receiving block 21 is attached to the housing 20 to close the opening 20a. In the embodiment, the heat-receiving block 21 is a plate of a highly thermally conductive material including metal such as iron or aluminum, and is attached to the outer surface of the housing 20 to close the opening 20a. Electronic components that generate heat, or more specifically, the switching elements SW1, SW2, and SW3, are attached to the first main surface 21a of the heat-receiving block 21. The heat transfer members 22 are attached to the second main surface 21b opposite to the first main surface 21a. For the vehicle 100 located horizontally, the first main surface 21a and the second main surface 21b extend horizontally.

Each heat transfer member 22 extends away from the second main surface 21b and transfers, in the direction away from the second main surface 21b, heat transferred from the electronic components through the heat-receiving block 21. In the embodiment, each heat transfer member 22 includes a heat pipe that contains a coolant. More specifically, each heat transfer member 22 serving as a heat pipe includes a header 24 attached to the heat-receiving block 21 and a branch pipe 25 attached to the header 24 and continuous with the header 24. The header 24 and the branch pipe 25 contain a coolant in vapor and liquid phases at ordinary temperature. An example of the coolant is water. In the embodiment, the headers 24 and the branch pipes 25 are symmetrically arranged with respect to an XZ plane.

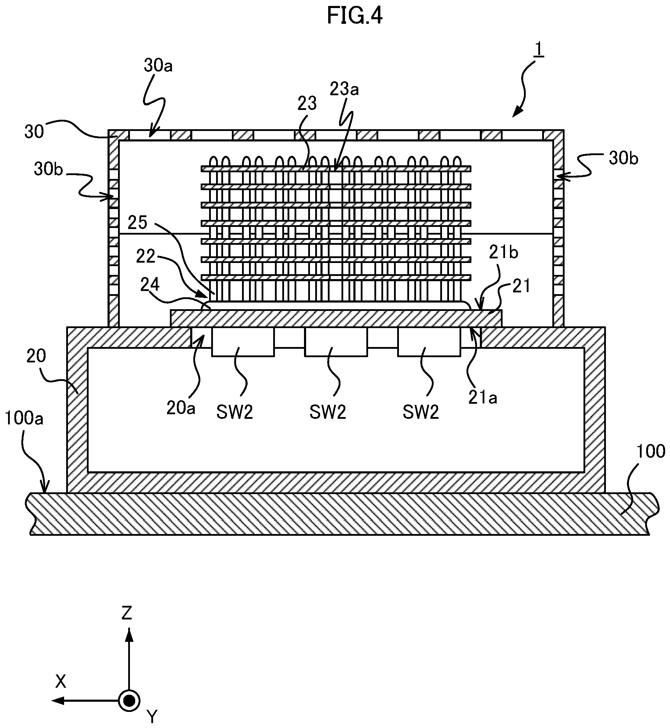

As illustrated in FIG. 3 and FIG. 4 that is a cross-sectional view taken along line IV-IV as viewed in the direction indicated by the arrows in FIG. 3, multiple headers 24 extending in X-direction are arranged in Y-direction. In the embodiment, twenty headers 24 extending in X-direction are arranged in Y-direction. Each header 24 is received in a groove on the second main surface 21b of the heat-receiving block 21 and attached to the heat-receiving block 21 by, for example, bonding with an adhesive, welding, or soldering. Each header 24 is a pipe formed from a highly thermally conductive material including metal such as iron or aluminum. Each header 24 receives multiple branch pipes 25.

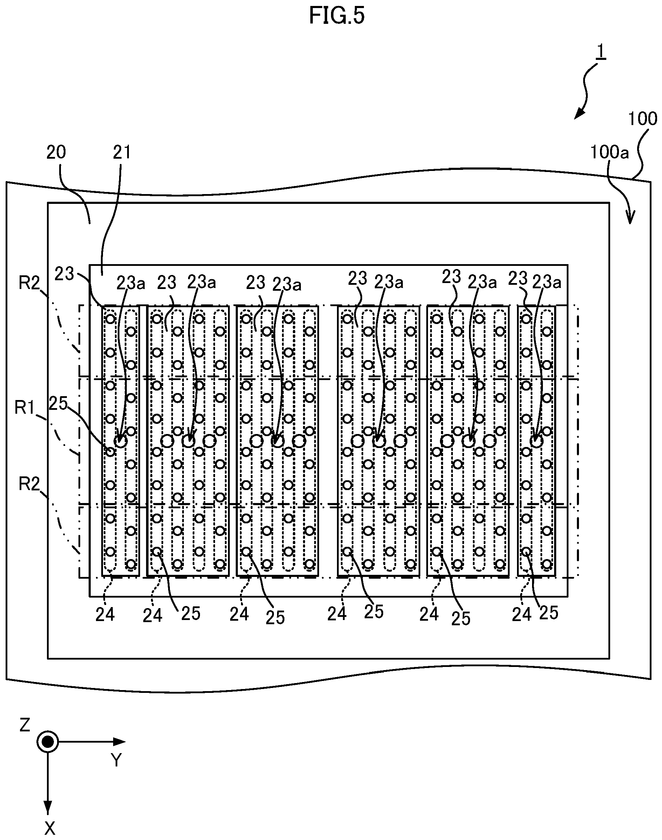

Each branch pipe 25 extends in a direction away from the heat-receiving block 21, for example, in the positive Z-direction. Each branch pipe 25 is attached to the corresponding header 24 by, for example, welding, brazing, or soldering and is continuous with the header 24. In the embodiment, as illustrated in FIG. 5, eight branch pipes 25 arranged in X-direction are attached to one header 24. In FIG. 5, the cover 30 is not illustrated. Each branch pipe 25 is formed from a highly thermally conductive material including metal such as iron or aluminum.

Each branch pipe 25 has a dimension in Z-direction below a vehicle limit in the cross section taken perpendicular to the travel direction of the vehicle 100, or more specifically, in a YZ plane. The vehicle limit indicates a maximum dimension of the vehicle 100. In the embodiment, as illustrated in FIG. 3, the dimension of the branch pipes 25 in Z-direction attached to the two headers 24 at each of two ends in Y-direction is shorter than the dimension of the branch pipes 25 in Z-direction attached to the eight headers 24 at the middle in Y-direction. Four headers 24 are arranged between the two headers 24 at the two ends in Y-direction and the eight headers 24 at the middle in Y-direction. The dimension of the branch pipes 25 in Z-direction attached to the four headers 24 is shorter than the dimension of the branch pipes 25 in Z-direction attached to the eight headers 24, and is longer than the dimension of the branch pipes 25 in Z-direction attached to the two headers 24.

The fins 23 are attached to the heat transfer members 22. More specifically, the fins 23 are attached to the heat transfer members 22 to receive the heat transfer members 22 in through-holes in the fins 23. The fins 23 attached to the heat transfer members 22 dissipate heat transferred from the electronic components through the heat-receiving block 21 and the heat transfer members 22 into ambient air. In the embodiment, the fins 23 are plates of a highly thermally conductive material including metal such as iron or aluminum.

At least one of the fins 23 has at least one ventilation hole 23a to guide air in the direction away from the second main surface 21b, for example, in the positive Z-direction. The ratio of the opening area of the ventilation holes 23a is higher in a first region of the fins 23 including the middle of the fins 23 in X-direction or Y-direction than in second regions located across the first region and having the same area as the first region. More specifically, the ratio of the opening area of the ventilation holes 23a in the main surface of the first region including the middle of the main surface of the fins 23 in X-direction or Y-direction is higher than the ratio of the opening area of the ventilation holes 23a in the main surfaces of the second regions located across the first region and having the same area as the first region.

In the embodiment, as illustrated in FIG. 5, each fin 23 has multiple circular ventilation holes 23a arranged linearly in Y-direction in a first region R1 surrounded by the dot-dash line and including the middle of the fin 23 in X-direction. Each fin 23 has no ventilation hole 23a in second regions R2 located across the first region R1 and surrounded by the two-dot-dash lines. The second regions R2 are located across the first region R1 in X-direction. The area of the first region R1 is equal to the sum of the areas of the second regions R2 located in the positive and negative X-directions from the first region R1.

The first region R1 has the ventilation holes 23a, but the second regions R2 have no ventilation holes 23a. Thus, the ratio of the opening area of the ventilation holes 23a in the first region R1 of each fin 23 is higher than the ratio of the opening area of the ventilation holes 23a in the second regions R2 of the fin 23.

To enhance the cooling performance of the electronic component when the vehicle 100 is traveling, the main surfaces of the fins 23 are preferably parallel to X-axis. The passing air created by the traveling vehicle 100 flows in X-direction. Thus, the fins 23 with the main surfaces parallel to X-axis can efficiently transfer heat to passing air flowing between the fins 23.

To cool the electronic components through natural convection when the vehicle 100 is stopped, the fins 23 have the ventilation holes 23a as described above. Air heated by heat transferred from the fins 23 moves through the ventilation holes 23a in the positive Z-direction. This airflow causes a flow of air from outside the cover 30 into the cover 30 and transfer of heat from the fins 23 to the inflow air. In the in-vehicle device 1, the ventilation holes 23a are formed in the first region R1 of each fin 23 in X-direction, instead of being formed across the entire surface of the fin 23. Thus, air flowing from the outside moves in the positive Z-direction after reaching the first region R1 of each fin 23 in X-direction. This airflow can cool the electronic components including the switching elements SW1, SW2, and SW3 also when the vehicle 100 is stopped.

In the embodiment, the multiple fins 23 are arranged in Y-direction and Z-direction. As illustrated in FIG. 3, six fins 23 are arranged in Y-direction. The fins 23 at each end in Y-direction are four fins 23 arranged in Z-direction. The fins 23 adjacent to the fins 23 at each end in Y-direction are five fins 23 arranged in Z-direction. The fins 23 at the middle in Y-direction are seven fins 23 arranged in Z-direction. The fins 23 are attached to the heat transfer members 22, or more specifically, to the branch pipes 25 with main surface of each fin 23 horizontally located for the vehicle 100 that is located horizontally.

The cover 30 is attached to the housing 20 to cover the heat-receiving block 21, the heat transfer members 22, and the fins 23. The cover 30 has multiple ventilation holes 30a in a surface extending in X-direction. The ventilation holes 30a allow outside air to flow into the cover 30 and allow air flowing near the heat transfer members 22 and the fins 23 to flow out of the cover 30. As illustrated in FIG. 4, the cover 30 has multiple ventilation holes 30b in a surface intersecting with X-direction. The ventilation holes 30b allow outside air to flow into the cover 30 and allow air flowing near the heat transfer members 22 and the fins 23 to flow out of the cover 30.

Cooling of the electronic components of the electronic device 1 with the above structure is described below. Heat generated by at least one of the switching element SW1, SW2, or SW3 is transferred to the coolant through the heat-receiving block 21 and the header 24. Thus, the coolant evaporates. The evaporated coolant flows into the branch pipe 25 from the header 24 and moves in the branch pipes 25 in the positive Z-direction. While moving in the positive Z-direction, the coolant transfers heat to ambient air around the heat transfer members 22 through the branch pipes 25 and the fins 23 and is cooled and liquefies. The liquefied coolant moves in the negative Z-direction along the inner walls of the branch pipes 25. As described above, the coolant circulates while repeatedly evaporating and liquefying to transfer heat generated by at least any of the switching element SW1, SW2, or SW3 to ambient air around the heat transfer members 22 and to cool the switching elements SW1, SW2, and SW3 generating heat.

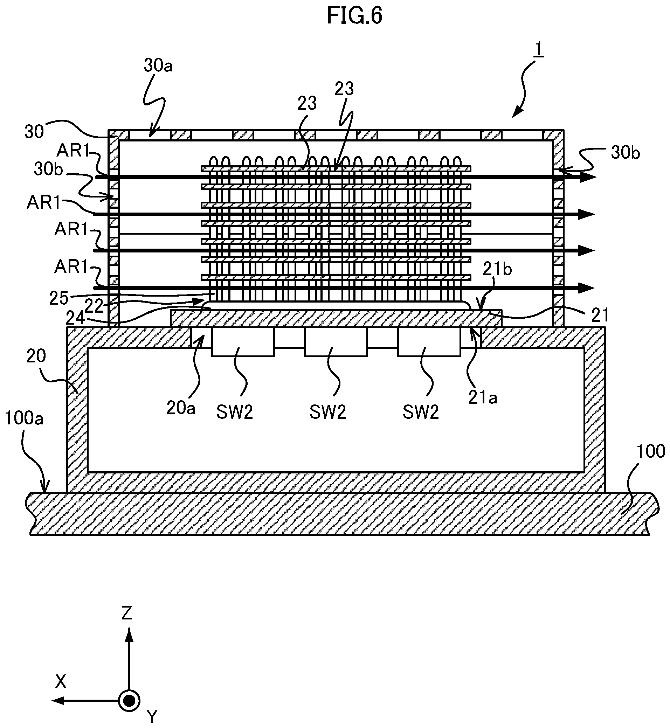

For example, when the vehicle 100 travels in the positive X-direction, passing air flowing in the negative X-direction as indicated by arrows AR1 in FIG. 6 occurs. For simplicity, FIG. 6 illustrates a part of the airflow. The passing air flows between the fins 23. The passing air flowing between the fins 23 receives heat transferred from the fins 23 and cools the switching elements SW1, SW2, and SW3.

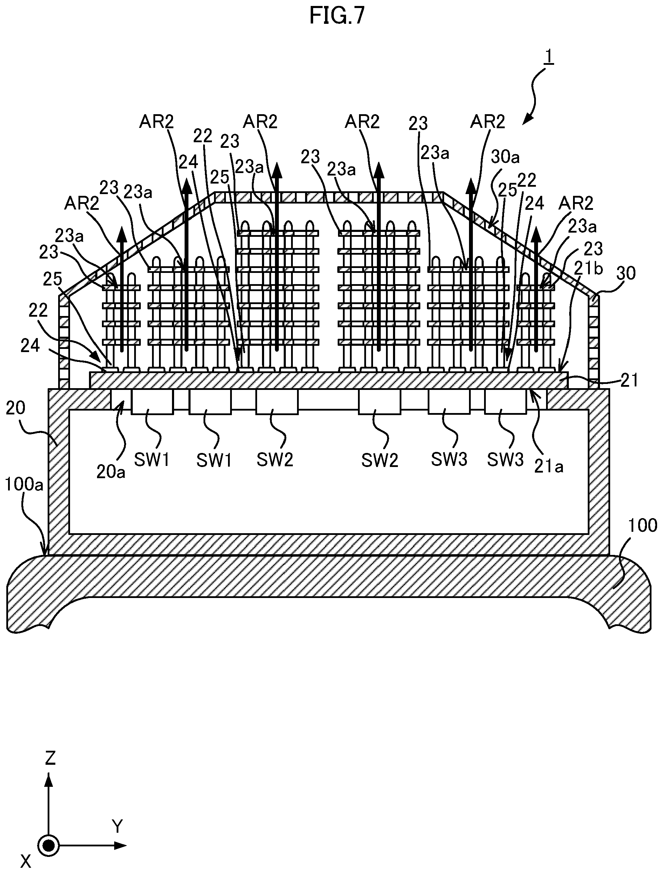

When the vehicle 100 is stopped, no passing air illustrated in FIG. 6 occurs. The fins 23 included in the electronic device 1 have the ventilation holes 23a. Thus, air heated with heat transferred from the fins 23 or the branch pipes 25 moves in the positive Z-direction through the ventilation holes 23a as indicated by arrows AR2 in FIG. 7. For simplicity, FIG. 7 illustrates a part of the airflow. Air moving in the positive Z-direction flows out of the cover 30 through the ventilation holes 30a in the cover 30 in a vertically upper portion.

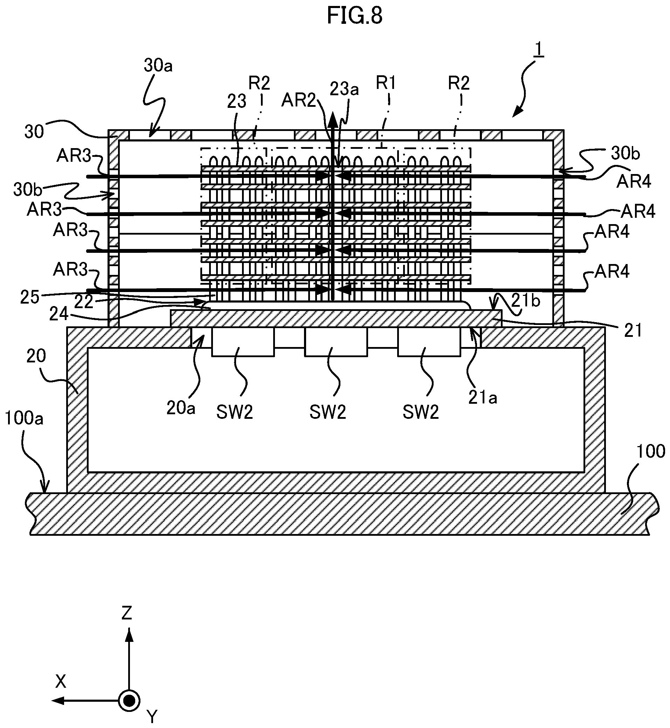

When air inside the cover 30 flows out through the ventilation holes 30a, as indicated by arrows AR3 and AR4 in FIG. 8, air outside the cover 30 flows into the cover 30 through the ventilation holes 30b in the surfaces of the cover 30 intersecting with X-direction. For simplicity, FIG. 8 illustrates a part of the airflow. More specifically, as indicated by arrows AR3, air flowing into the cover 30 through the ventilation holes 30b in the surface of the cover 30 facing in the positive X-direction flows between the fins 23 in the negative X-direction and reaches the first region R1 of the fins 23 in X-direction. As indicated by arrows AR4, air flowing into the cover 30 through the ventilation holes 30b in the surface of the cover 30 facing in the negative X-direction flows between the fins 23 in the positive X-direction and reaches the first region R1 of the fins 23 in X-direction.

Air flowing into the cover 30 receives heat transferred from the fins 23 to be heated while flowing between the fins 23 in the above manner, and reaches the first region R1 of the fins 23 in X-direction. The heated air moves in the positive Z-direction through the ventilation holes 23a in the fins 23 and flows out of the cover 30 through the ventilation holes 30a. The fins 23 with the ventilation holes 23a cause an airflow in the positive Z-direction. The switching elements SW1, SW2, and SW3 can thus be cooled through natural convection in this manner also when the vehicle 100 is stopped.

Increasing the sum of the opening areas of the ventilation holes 23a in the fins 23 reduces the dissipation area and such reduction degrades the cooling performance. Thus, the sum of the opening areas of the ventilation holes 23a is preferably determined based on the cooling performance intended when the vehicle is traveling and stopped. More specifically, the number of ventilation holes 23a and the shape of each ventilation hole 23a is preferably determined based on the cooling performance intended when the vehicle is traveling and stopped.

As described above, the electronic device 1 according to the embodiment includes the fins 23 with the ventilation holes 23a. When the vehicle 100 is stopped, air heated with heat transferred from the fins 23 in the cover 30 moves in the positive Z-direction through the ventilation holes 23a. When air inside the cover 30 moves in the positive Z-direction through the ventilation holes 23a and flows out of the cover 30 through the ventilation holes 30a in the cover 30, air outside the cover 30 flows into the cover 30. As described above, an airflow occurs also when the vehicle 100 is stopped. Thus, the electronic device 1 can cool the electronic components including the switching elements SW1, SW2, and SW3 through natural convection.

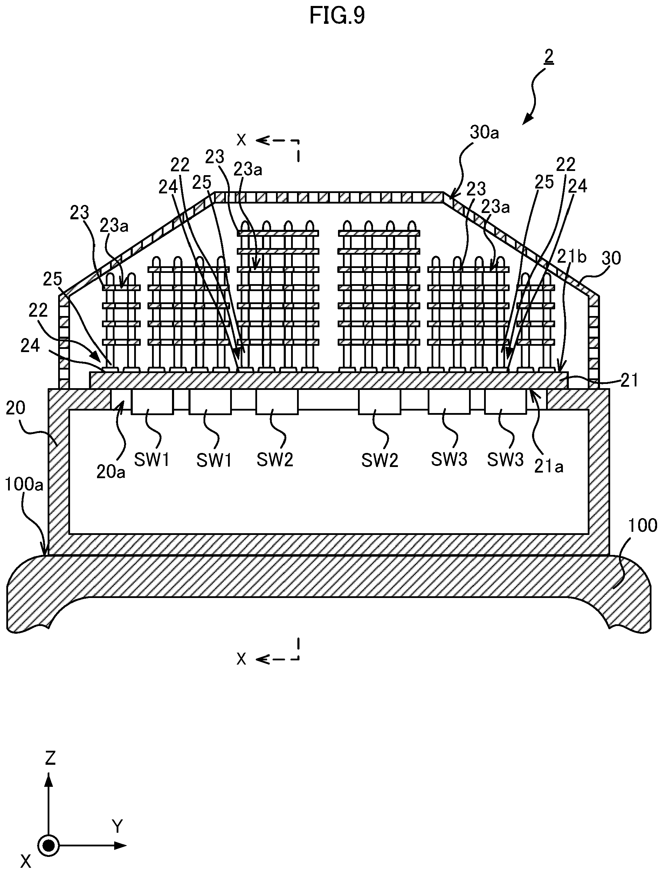

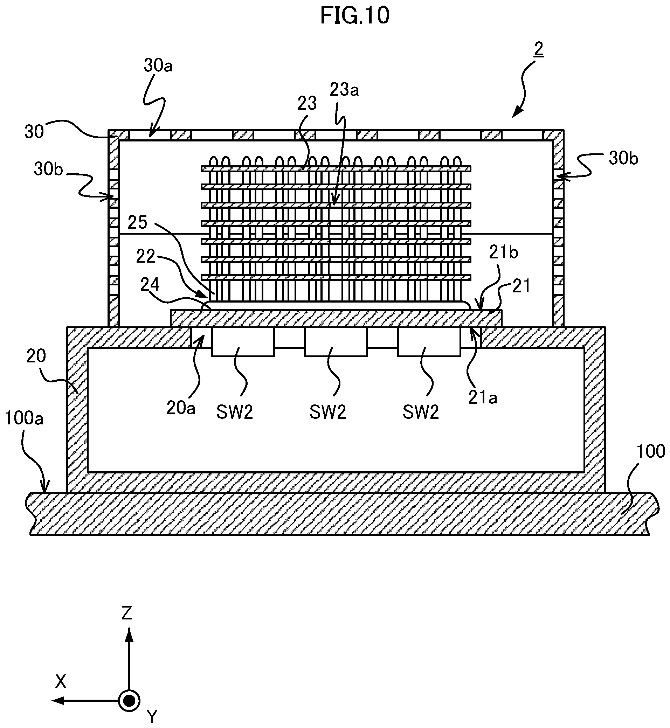

The present disclosure is not limited to the above embodiment. For example, the ventilation holes 23a may be formed in only a part of one or more of the fins 23. For example, FIG. 9 and FIG. 10 that is a cross-sectional view taken along line X-X as viewed in the direction indicated by the arrows in FIG. 9 illustrate an electronic device 2. The electronic device 2 includes fins 23 arranged as in the electronic device 1. The electronic device 2 has no ventilation holes 23a in the four fins 23 located at the middle in Y-direction and in the positive Z-direction.

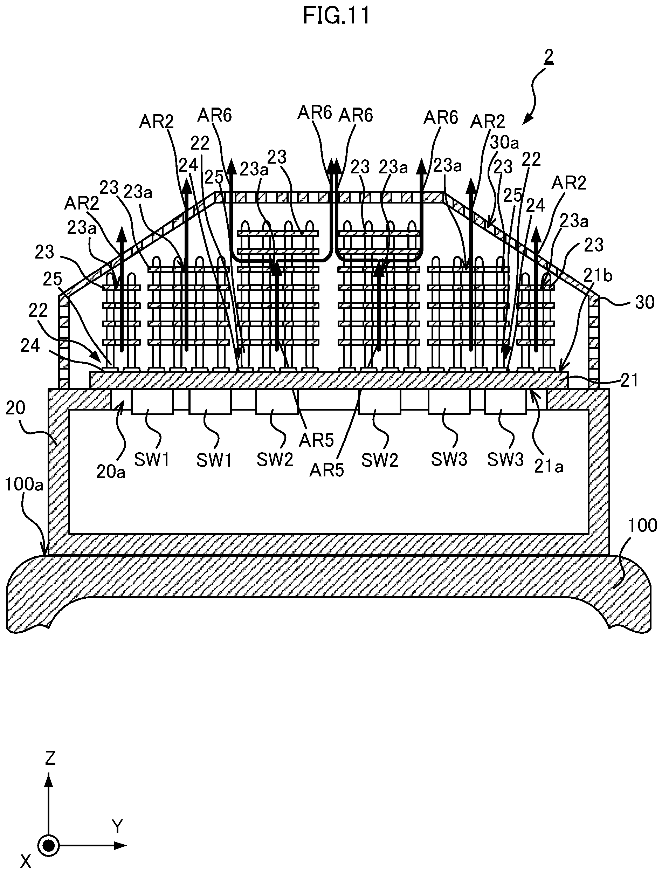

As indicated by arrows AR2 in FIG. 11, in the electronic device 2, air heated with heat transferred from the fins 23 moves in the positive Z-direction through the ventilation holes 23a. In the first region R1 in Y-direction, as indicated by arrows AR5, air heated with heat transferred from the fins 23 moves in the positive Z-direction through the ventilation holes 23a and reaches the fins 23 with no ventilation holes 23a. As indicated by arrows AR6, air reaching the fins 23 with no ventilation holes 23a moves in the positive Z-direction around the fins 23 with no ventilation holes 23a. Some of the fins 23 with no ventilation holes 23a can reduce degradation of cooling performance with the passing air.

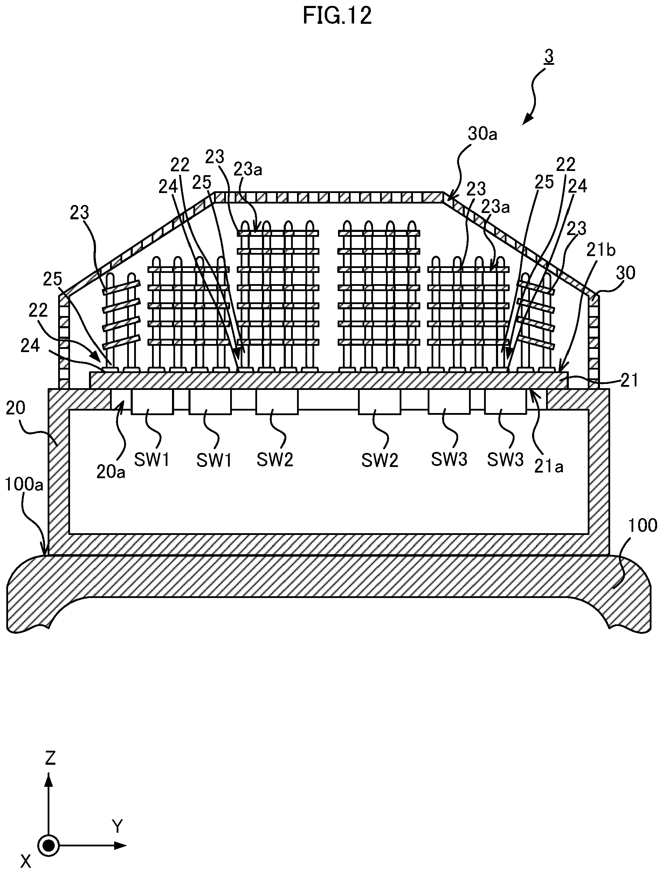

FIG. 12 illustrates an electronic device 3 as another example. In the electronic device 3, the fins 23 at the middle in Y-direction have the ventilation holes 23a, and the fins 23 at two ends in Y-direction have no ventilation holes 23a. In other words, the fins 23 at two ends in Y-direction are attached to the heat transfer members 22, or more specifically, to the branch pipes 25 when one of the two ends in Y-direction nearer the middle of the vehicle 100 has one vertical end located higher than the other vertical end for the vehicle 100 located horizontally.

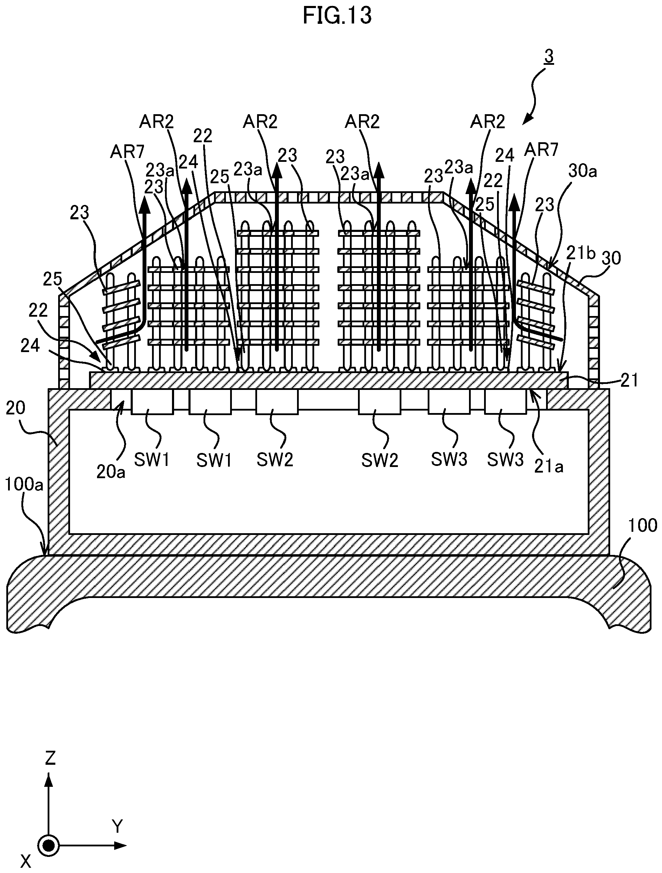

In the electronic device 3, as indicated by arrows AR2 in FIG. 13, air heated with heat transferred from the fins 23 moves in the positive Z-direction through the ventilation holes 23a. At two ends in Y-direction, as indicated by arrows AR7, air heated with heat transferred from the fins 23 moves along the fins 23 toward the center of the vehicle 100, and then moves between the fins 23 in the positive Z-direction.

In the electronic device 1, the ventilation holes 23a in the fins 23 have the same shape and the same size, but is not limited to the above-mentioned examples. The number of ventilation holes 23a may be other than in the above example. More specifically, each fin 23 may have any number of ventilation holes 23a with any shape and any size with the ratio of the opening area of the ventilation holes 23a in the first region R1 of the fins 23 in X-direction or Y-direction higher than the ratio of the opening area of the ventilation holes 23a in the second regions R2 located across the first region R1.

For example, instead of being circular, the ventilation holes 23a may be elliptic or square. The ventilation holes 23a may have different shapes.

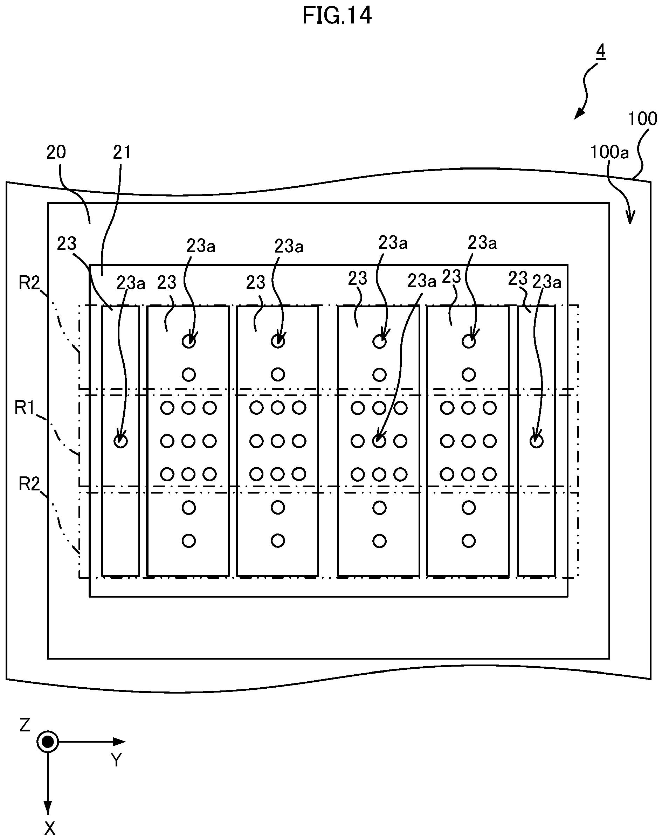

FIG. 14 illustrates an electronic device 4 as another example. In the electronic device 4, the ventilation holes 23a in the fins 23 have the same shape, but the first region R1 in X-direction surrounded by the dot-dash line has more ventilation holes 23a than the second regions R2 located across the first region R1 in X-direction and surrounded by the dot-dash lines. For simplicity, in FIG. 14, the cover 30 and the heat transfer members 22 are not illustrated. The first region R1 has more ventilation holes 23a than the second regions R2. Thus, a larger part of air flowing from outside the cover 30 moves from the second regions R2 to the first region R1 and flows in the positive Z-direction through the ventilation holes 23a in the first region R1.

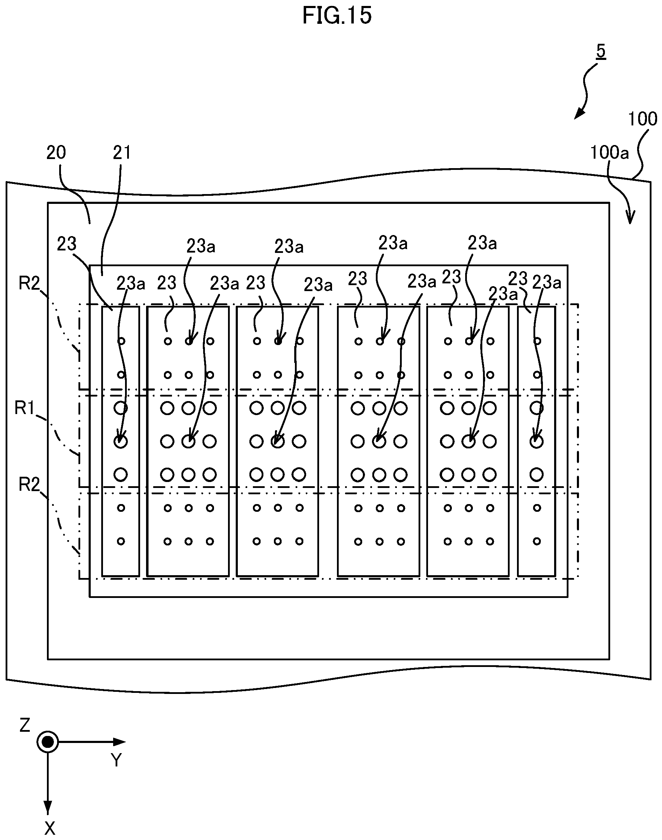

FIG. 15 illustrates an electronic device 5 as another example. In the electronic device 5, the first region R1 has larger ventilation holes 23a than the second regions R2. For simplicity, the cover 30 and the heat transfer members 22 are not illustrated in FIG. 15. The first region R1 has larger ventilation holes 23a. Thus, a larger part of air flowing from outside the cover 30 moves from the second regions R2 to the first region R1 and flows in the positive Z-direction through the ventilation holes 23a in the first region R1.

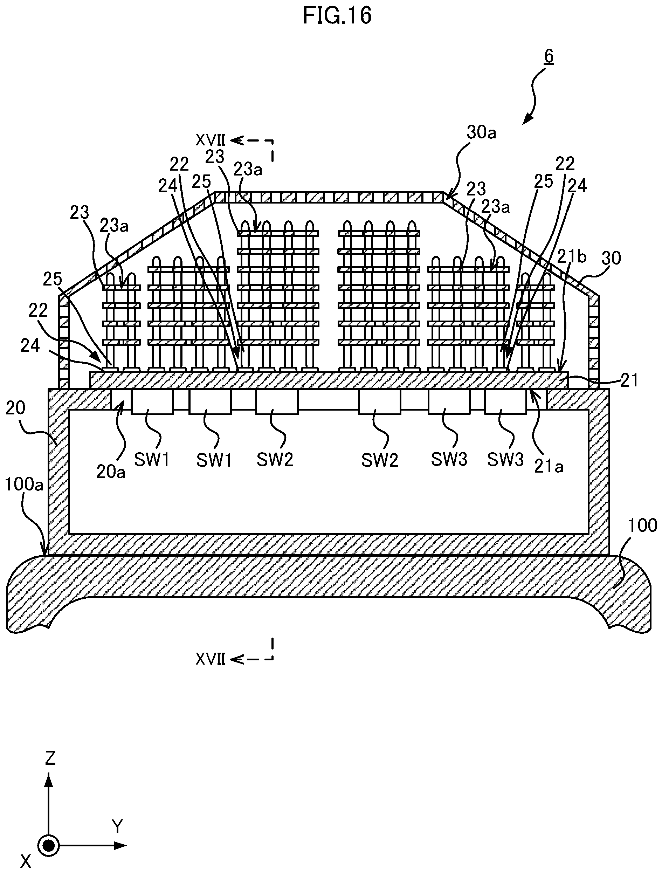

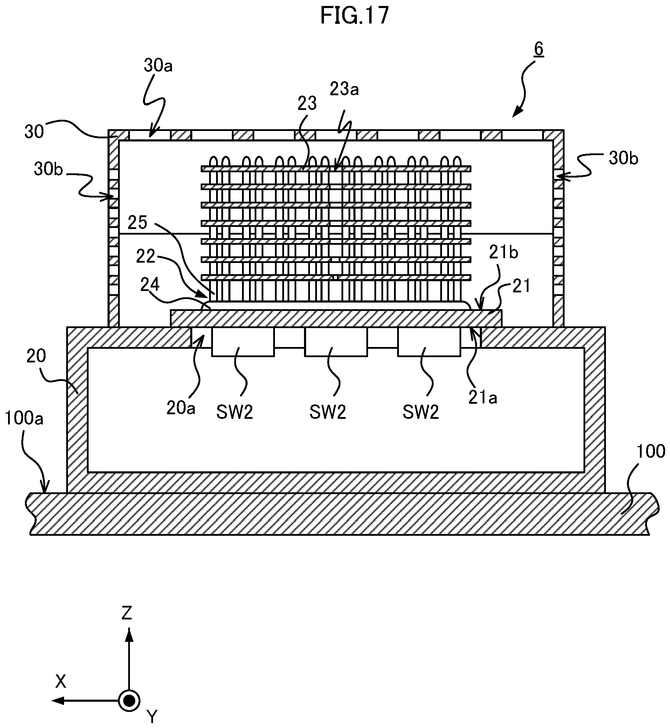

In the electronic device 1, the ventilation holes 23a arranged in Z-direction between the fins 23 are arranged at the same position and have the same shape, but may be arranged at different positions and have different shapes. For example, FIG. 16 and FIG. 17 that is a cross-sectional view taken along line XVII-XVII as viewed in the direction indicated by the arrows in FIG. 16 illustrate an electronic device 6. In the electronic device 6, the sum of the opening areas of the ventilation holes 23a in the fins 23 adj acent to the heat-receiving block 21 is smaller than the sum of the opening areas of the ventilation holes 23a in the fins 23 farther from the heat-receiving block 21 than the fins 23 adjacent to the heat-receiving block 21.

More specifically, the ventilation holes 23a in the fins 23 adjacent to the heat-receiving block 21 each has a smaller diameter than the ventilation holes 23a in the fins 23 farther from the heat-receiving block 21 than the fins 23 adjacent to the heat-receiving block 21. The fins 23 adjacent to the heat-receiving block 21 each have one ventilation hole 23a at the middle in Y-direction, whereas the fins 23 farther from the heat-receiving block 21 than the fins 23 adjacent to the heat-receiving block 21 each have three ventilation holes 23a.

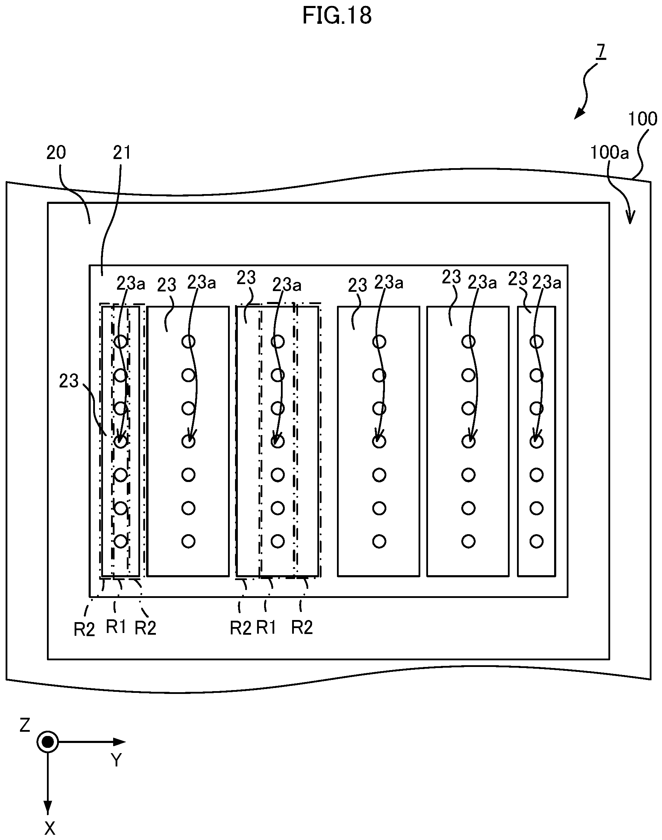

The fins 23 in the electronic device 1 have the ventilation holes 23a arranged linearly in Y-direction in the first region R1 including the middle in X-direction, but the ventilation holes 23a may be located at different positions. FIG. 18 illustrates an electronic device 7, or an example that is adjacent to another in-vehicle device in X-direction and that more easily allows air to flow into the cover 30 in Y-direction than in X-direction.

The fins 23 in the electronic device 7 have multiple circular ventilation holes 23a arranged linearly in X-direction in the first region R1 surrounded by the dot-dash line and including the middle of each fin 23 in Y-direction. The second regions R2 located across the first region R1 and surrounded by the two-dot-dash lines have no ventilation holes 23a. For simplicity, FIG. 18 illustrates the first region R1 and the second regions R2 located in some of the fins 23. The second regions R2 are located across the first region R1 in Y-direction. The area of the first region R1 is equal to the sum of the areas of the second regions R2 located in the positive and negative Y-directions from the first region R1.

The first region R1 has the ventilation holes 23a, whereas the second regions R2 have no ventilation holes 23a. Thus, the ratio of the opening area of the ventilation holes 23a in the first region R1 of each fin 23 is higher than the ratio of the opening area of the ventilation holes 23a in the second regions R2 of the fin 23.

The first region R1 and the second regions R2 may be located at positions other than in the above example. Being located across the first region R1 includes surrounding the first region R1. For example, the second regions R2 may be located to surround the outer periphery of the first region R1.

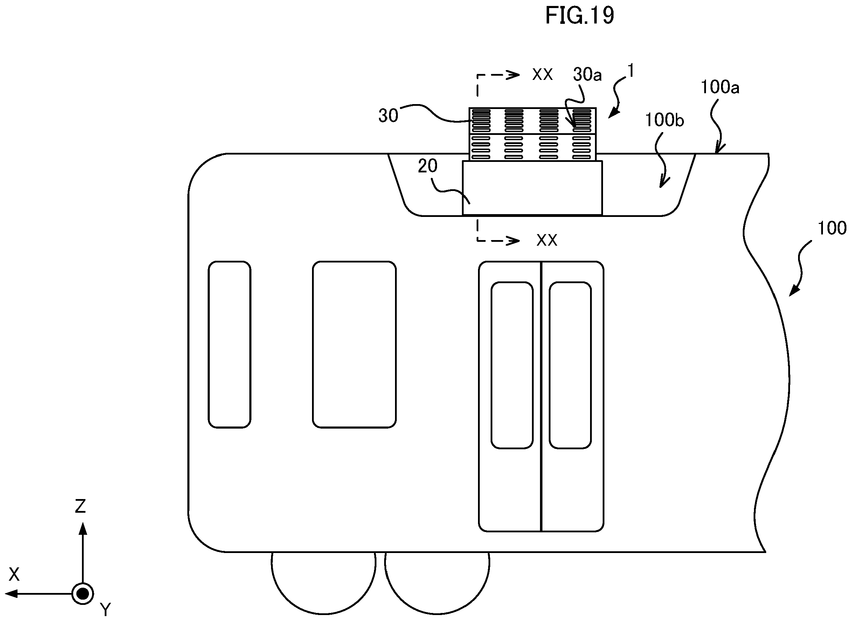

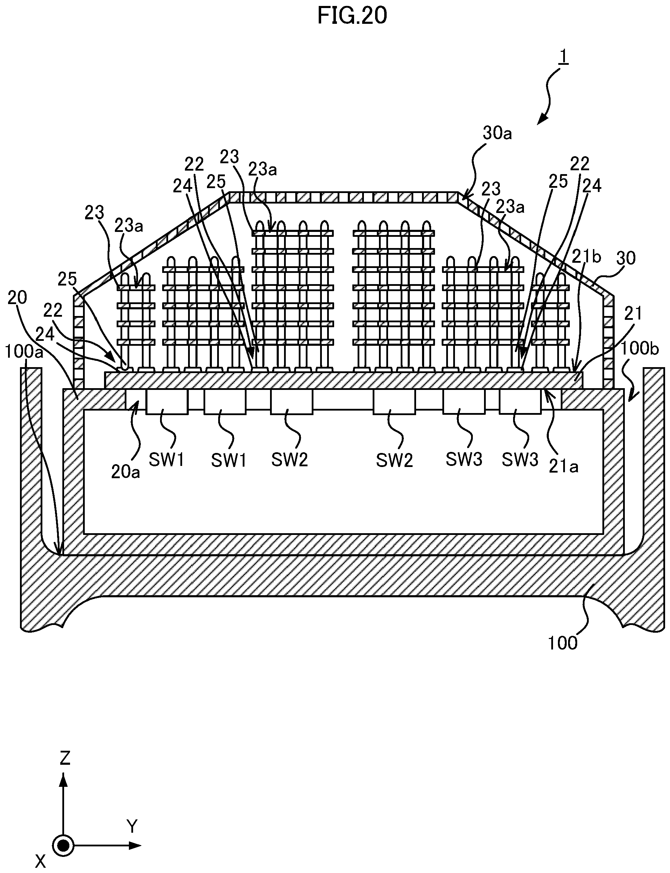

The electronic devices 1 to 7 may be installed at positions other than in the above example. For example, as in FIG. 19 and FIG. 20 that is a cross-sectional view of the electronic device 1 taken along line XX-XX as viewed in the direction indicated by the arrows in FIG. 19, the electronic device 1 may be installed at a container 100b in the roof 100a of the vehicle 100. The container 100b is a recess on the roof 100a of the vehicle 100 and is open vertically upward. The open surface of the container 100b is flush with the vertically upper end of the roof 100a of the vehicle 100. The container 100b accommodates the housing 20 of the electronic device 1. More specifically, the bottom surface of the housing 20 is attached to the bottom surface of the container 100b.

To enhance the cooling performance of the electronic device 1, at least parts of the heat transfer members 22 and at least parts of the fins 23 are preferably located vertically above the upper end of the roof 100a.

The inverter 14 may supply power to any load, other than the air-conditioning device 62, that operates when the vehicle 100 is stopped. In an example, the inverter 14 can supply power to a lighting device or a door opening/closing device in the vehicle 100.

The housing 20 may have any shape that can accommodate the electronic components including the switching elements SW1, SW2, and SW3 and can be attached to the roof 100a.

In addition to the above example, the heat-receiving block 21 may have any shape that covers the opening 20a in the housing 20 and can receive the electronic components including the switching elements SW1, SW2, and SW3 and the heat transfer members 22. For example, the heat-receiving block 21 may be a plate with a nonuniform thickness. The heat-receiving block 21 may be a single plate or a combination of multiple plates.

The electronic components attached to the heat-receiving block 21 may be, for example, any electronic components, other than the switching elements SW1, SW2, and SW3, that are accommodated in the housing 20 such as a thyristor or a diode.

The heat transfer members 22 may not be heat pipes but may be any members that transfer heat in the direction away from the second main surface 21b. For example, the heat transfer members 22 may be rod-like members formed from a highly thermally conductive material including metal such as iron or aluminum.

The heat transfer members 22, or more specifically, the branch pipes 25, may be arranged in any manner other than in the above example to cool the electronic components through natural convection.

The heat transfer members 22, or more specifically, the headers 24 and the branch pipes 25, may have any shapes other than in the above example to transfer heat in the direction away from the second main surface 21b. For example, the headers 24 and the branch pipes 25 may be integral with each other to form a U-shaped or L-shaped heat pipe as the heat transfer member 22. In another example, each of the headers 24 and the branch pipes 25 may have an elongated circular cross section rather than a circular cross section when taken perpendicular to a direction in which the headers 24 and the branch pipes 25 extend. The elongated circular shape is acquired by deforming a circle to narrow a part of the dimension, and includes an ellipse, a streamline shape, and an oval. The oval refers to an outline of outer edges of two circles with the same diameter connected with two straight lines.

The fins 23 may be formed from the same material, or at least any of the fins 23 may be formed from a material different from the material of the other fins 23. When at least any of the fins 23 is formed from a material different from the material of the other fins 23, the fin 23 has thermal conductivity different from that of the other fins 23. The fins 23 located vertically upward preferably have higher thermal conductivity than the fins 23 located vertically downward. For example, the fins 23 located vertically upward may be formed from copper, and the fins 23 located vertically downward may be formed from aluminum.

Any number of fins 23 in any shape having a ventilation hole 23a at the middle in X-direction or Y-direction to guide air in the positive Z-direction may be arranged in any manner other than in the above examples. For example, each fin 23 may be a plate with a curved surface or with a nonuniform thickness. In another example, each fin 23 may be a plate attached to the corresponding heat transfer member 22 with its main surface inclined with respect to the horizontal plane for the vehicle 100 located horizontally. In another example, the fins 23 may have different shapes. For example, the multiple fins 23 with different dimensions in Y-direction may be arranged in Z-direction.

The cover 30 may have any shape that covers the heat transfer members 22 and the fins 23 and allows air to flow inside. In an example, the cover 30 may have a vertically upper surface that is curved. In another example, the cover 30 may have a vertically upper surface that is flat. The cover 30 may have a shape that maximizes the internal space below the vehicle limit.

The electronic devices 1 to 7 may each be installable on a DC feeding railway vehicle, rather than on an AC feeding railway vehicle. The electronic devices 1 to 7 may each be installable on any vehicle that creates passing air such as a trolley bus or a streetcar, rather than the railway vehicle.

The foregoing describes some example embodiments for explanatory purposes. Although the foregoing discussion has presented specific embodiments, persons skilled in the art will recognize that changes may be made in form and detail without departing from the broader spirit and scope of the invention. Accordingly, the specification and drawings are to be regarded in an illustrative rather than a restrictive sense. This detailed description, therefore, is not to be taken in a limiting sense, and the scope of the invention is defined only by the included claims, along with the full range of equivalents to which such claims are entitled.

### Reference Signs List

- 1, 2, 3, 4, 5, 6, 7: Electronic device
- 1a: Positive terminal
- 1b: Negative terminal
- 11, 15: Transformer
- 12: Converter
- 13,: 14Inverter
- 20: Housing
- 20a: Opening
- 21: Heat-receiving block
- 21a: First main surface
- 21b: Second main surface
- 22: Heat transfer member
- 23: Fin
- 23a, 30a, 30b: Ventilation hole
- 24: Header
- 25: Branch pipe
- 30: Cover
- 61: Motor
- 62: Air-conditioning device
- 100: Vehicle
- 100a: Roof
- 100b: Container
- AR1, AR2, AR3, AR4, AR5, AR6, AR7: Arrow
- C1: Capacitor
- R1: First Region
- R2: Second Region
- SW1, SW2, SW3: Switching element

## Claims

1. An electronic device installable on a vehicle, the electronic device comprising:
a heat-receiving block being heat conductive and having a first main surface to which an electronic component is attachable;
a heat transfer member attached to a second main surface of the heat-receiving block, the second main surface being opposite to the first main surface, the heat transfer member extending away from the second main surface to transfer, in a direction away from the second main surface, heat transferred from the electronic component through the heat-receiving block; and
one or more fins attached to the heat transfer member to dissipate heat transferred from the electronic component through the heat-receiving block and the heat transfer member into ambient air, at least one fin of the one or more fins having at least one ventilation hole to guide the ambient air in the direction away from the second main surface,
wherein the at least one fin of the one or more fins having the at least one ventilation hole has a first region including a middle of the at least one fin having the at least one ventilation hole in a travel direction or a width direction of the vehicle and second regions located across the first region and having a same area as the first region, and a ratio of an opening area of the at least one ventilation hole is higher in the first region than in the second regions.

2. The electronic device according to claim 1, further comprising:
a housing accommodating the electronic component and having an opening in a vertically upper portion thereof, the housing being installable on a roof of the vehicle,
wherein the heat-receiving block is attached to the housing with the first main surface closing the opening in the housing.

3. The electronic device according to claim 1 or 2, wherein
the at least one ventilation hole includes a plurality of ventilation holes arranged linearly in the width direction in the first region including a middle of the at least one fin having the at least one ventilation hole in the travel direction.

4. The electronic device according to claim 1 or 2, wherein
the at least one ventilation hole includes a plurality of ventilation holes arranged linearly in the travel direction in the first region including a middle of the at least one fin having the at least one ventilation hole in the width direction.

5. The electronic device according to any one of claims 1 to 4, wherein
the one or more fins are three or more fins arranged in the width direction, and
a fin of the three or more fins in a middle in the width direction is a plate with a flat main surface facing the heat-receiving block, and attached to the heat transfer member with the flat main surface horizontally located, with the vehicle located horizontally.

6. The electronic device according to claim 5, wherein
fins of the three or more fins at two ends in the width direction are each attached to the heat transfer member with, for the vehicle located horizontally, one of two ends of each of the fins at the two ends in the width direction nearer a middle of the vehicle located vertically higher than the other of the two ends.

7. The electronic device according to claim 5 or 6, wherein
the fin of the three or more fins in the middle in the width direction has the at least one ventilation hole, and fins of the three or more fins at two ends in the width direction have no ventilation hole.

8. The electronic device according to any one of claims 1 to 5, wherein
each of the one or more fins is a plate with a flat main surface facing the heat-receiving block, and attached to the heat transfer member with the flat main surface horizontally located for the vehicle located horizontally.

9. The electronic device according to any one of claims 1 to 8, wherein
the one or more fins include a plurality of fins arranged in a direction away from the heat-receiving block.

10. The electronic device according to claim 9, wherein
the plurality of fins include one or more adjacent fins located adjacent to the heat-receiving block, and a sum of opening areas of ventilation holes in the one or more adjacent fins is smaller than a sum of opening areas of ventilation holes in one or more fins of the plurality of fins located farther from the heat-receiving block than the one or more adjacent fins.
